(19) Europäisches Patentamt
European Patent Office
Office européen des brevets

(11) **EP 3 235 002 B1**

(12) **EUROPÄISCHE PATENTSCHRIFT**

(45) Veröffentlichungstag und Bekanntmachung des Hinweises auf die Patenterteilung:
**29.01.2020 Patentblatt 2020/05**

(51) Int Cl.:
*H01L 29/739* *(2006.01)*          *H01L 29/06* *(2006.01)*
*H01L 29/08* *(2006.01)*          *H01L 21/33* *(2006.01)*

(21) Anmeldenummer: **15813251.4**

(22) Anmeldetag: **04.11.2015**

(86) Internationale Anmeldenummer:
**PCT/DE2015/000531**

(87) Internationale Veröffentlichungsnummer:
**WO 2016/095885 (23.06.2016 Gazette 2016/25)**

(54) **TUNNEL-FELDEFFEKTTRANSISTOR SOWIE VERFAHREN ZU DESSEN HERSTELLUNG**

TUNNEL FIELD EFFECT TRANSISTOR AND METHOD OF FABRICATION THEREOF

TRANSISTOR À EFFET DE CHAMP TUNNEL ET SON PROCÉDÉ DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.12.2014 DE 102014018382**

(43) Veröffentlichungstag der Anmeldung:
**25.10.2017 Patentblatt 2017/43**

(73) Patentinhaber: **Forschungszentrum Jülich GmbH 52425 Jülich (DE)**

(72) Erfinder:
• ZHAO, Qing-Tai
  52428 Jülich (DE)
• MANTL, Siegfried
  52428 Jülich (DE)
• BLAESER, Sebastian
  41464 Neuss (DE)

(56) Entgegenhaltungen:
US-A1- 2009 101 972    US-A1- 2011 147 838
US-A1- 2011 278 542    US-A1- 2012 199 917
US-A1- 2014 054 657    US-B1- 8 384 122

• KNOLL L ET AL: "Si tunneling transistors with high on-currents and slopes of 50 mV/dec using segregation doped Nisi 2 tunnel junctions", SOLID-STATE DEVICE RESEARCH CONFERENCE (ESSDERC), 2012 PROCEEDINGS OF THE EUROPEAN, IEEE, 17. September 2012 (2012-09-17), Seiten 183-156, XP032466587, DOI: 10.1109/ESSDERC.2012.6343356 ISBN: 978-1-4673-1707-8

EP 3 235 002 B1

**Beschreibung**

Die Erfindung betrifft einen Tunnel-Feldeffekttransistor (TFET) mit vertikalem Tunnelpfad sowie ein Verfahren zur Herstellung eines solchen Tunnel-Feldeffekttransistors (TFET).

Stand der Technik

Für die Entwicklung von zunehmend leistungsfähigeren, mobilen Geräten sowie von Computern mit höherer Leistung sind energieeffizientere Transistoren unerlässlich. Die stetige Verkleinerung der Transistorgrößen und die Zunahme der Packungsdichte von über $10^9$ Transistoren je Chip verursacht einen zu großen Energieverbrauch und damit verbunden eine problematische Wärmeentwicklung. Obwohl die konventionellen Feldeffekttransistoren (MOSFETs) stetig verbessert werden und dadurch auch der Energieverbrauch reduziert wird, begrenzt das Einschaltverhalten prinzipiell die Energieeffizienz. Dies hat mit der bei Raumtemperatur thermisch verbreiterten Energieverteilung der Ladungsträger zu tun, die in den Transistorkanal injiziert werden. Das Einschaltverhalten kann durch die sogenannte inverse Unterschwellensteigung (S) beschrieben werden, die angibt, um wie viele Millivolt (mV) die Gatespannung erhöht werden muss, um den Ausgangsstrom ($I_{on}$) um eine Dekade (dec) zu erhöhen. Bei Raumtemperatur ergibt sich ein minimales S von 60 mV/dec. Im Fall von Kurzkanaltransistoren, wie sie in High Performance Prozessoren eingesetzt werden, vergrößern Kurzkanaleffekte S auf etwa 100 mV/dec bei einer Gatelänge von 32 nm. Diese prinzipiellen Begrenzungen erhöhen auch den Ausstrom ($I_{off}$) bei gegebener Schwellenspannung und somit die Verluste.

Um den Energieverbrauch von Transistoren zu reduzieren, sollten die Betriebsspannung (= Drainspannung ($V_{dd}$)) und die inverse Unterschwellensteigung (S) reduziert werden. Der dynamische Energieverbrauch skaliert mit dem Quadrat von $V_{dd}$, wenn zusätzlich die Schaltfrequenz berücksichtigt wird, sogar mit der dritten Potenz von $V_{dd}$. Eine Verkleinerung von S ermöglicht eine Verkleinerung der Schwellenspannung ohne wesentlichen Anstieg von $I_{off}$.

Um diese Anforderungen zu erfüllen, ist eine neue Art von Schaltelementen erforderlich, die sogenannten "steep slope devices". Zu den vielversprechendsten Konzepten zählen sogenannte Band-zu-Band Tunneltransistoren (Band-to-band tunneling (BTBT) transistors), hier als Tunnel-FETs (TFET) bezeichnet, sowie MOSFETs mit einem vorgeschalteten Energiefilter. Letztere wurden wegen enormer technologischer Probleme noch nicht realisiert. Bisher hergestellte Tunnel-Feldeffekttransistoren erfüllen in der Regel die Erwartungen noch nicht, da die Ausgangsströme zu klein sind und S nur in einem nicht nutzbar kleinen Gatespannungsbereich < 60 mV/dec liegt.

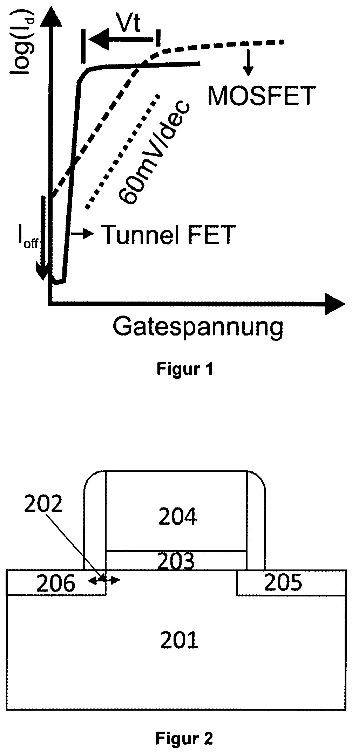

Figur 1 illustriert schematisch das Schaltverhalten eines konventionellen MOSFETs und eines Tunnel-Feldeffekttransistors. Dargestellt ist die Transferkennlinie des Stroms auf der Darinseite ($I_d$) gegen die Gatespannung. Die gestrichelte Linie zeigt die minimale inverse Unterschwellensteigung S für MOSFETs mit 60mV/dec. $V_t$ bezeichnet die Schwellenspannung. Nach Simulationsrechnungen können Tunnel-Feldeffekttransistoren ein S < 60mV/dec erreichen. Zudem kann der Tunnel-Feldeffekttransistor bei wesentlich kleineren Gatespannungen bereits voll eingeschaltet werden. Dadurch kann im Vergleich zu MOSFETs die Schwellenspannung $V_t$ (auf Grund des kleineren S) reduziert werden, ohne $I_{off}$ zu erhöhen und somit eine höhere Energieeffizienz erzielt werden.

Figur 2 zeigt den prinzipiellen Aufbau eines planaren Tunnel-Feldeffekttransistors, bestehend aus einer Source-Kanal-Drain-Struktur, beispielsweise einer p-i-n Struktur, mit einer Gateanordnung 203, 204, wobei die Gateanordnung vorteilhaft ein Gatedielektrikum 203 mit einer großen Permittivität (k) wie z. B. $HfO_2$ umfasst. Der Gatekontakt (Gateelektode) 204 wird mit Hilfe einer Metallschicht (z. B. TiN) realisiert. Source 206 und Drain 205 sind bei symmetrisch aufgebauten Transistoren austauschbar. Der Tunnelübergang 202 kann wahlweise an Source oder Drainseite realisiert werden. 201 deutet intrinsisches Silizium an.

Zur Vereinfachung sei für diesen Stand der Technik der Tunnelübergang am Source-zu-Kanal Übergang gewählt. Der Transistor wird in Sperrrichtung gepolt, das heißt für einen p-TFET wird der n$^+$-dotierte Source auf V = 0 gesetzt sowie an den p$^+$-dotierten Drain und das Gate eine negative Spannung angelegt. Für einen n-TFET wird analog die Polarität von Source und Drain sowie von Drain- bzw. Gatespannung getauscht. Dadurch werden im Kanal- und Drainbereich in der Regel das Leitungs- und Valenzband erhöht. Bei ausreichend großen Spannungen entsteht ein elektronischer Bandverlauf, bei dem Minoritätsladungsträger (hier Löcher) vom Leitungsband des Source in das Valenzband des Kanalmaterials tunneln. Die Tunnelwahrscheinlichkeit $T_{WKB}$ nach der WKB Näherung ist gegeben durch:

$$T_{\text{WKB}} \approx exp\left(-\frac{4\Lambda\sqrt{2m^*}E_g^{3/2}}{3q\hbar(\Delta\Phi + E_g)}\right)$$

(Gl. 1)

Dabei bezeichnet $\Lambda$ die natürliche Länge (engl. natural length), $m^*$ die effektive Masse der Ladungsträger, $E_g$ die Bandlücke, $\Delta\Phi$ die Potentialdifferenz zwischen Valenzbandunterkante im Kanal und Leitungsbandoberkante in Source, $q$ die Elektronenladung und $\bar{h}$ die Planck'sche Konstante geteilt durch $2\pi$. Die natürliche Länge $\Lambda$ ist die Summe aus $\Lambda_g$ und $\Lambda_{ch}$. Der erste Summand $\Lambda_g$ ist ein Maß für die elektrostatische Kontrolle des Transistors durch das Gate, der zweite Summand $\Lambda_{ch}$ beschreibt die Schärfe des Tunnelübergangs.

Die Feldabhängigkeit des Tunnelstromes ist durch das Kane Modell gegeben. Dementsprechend nimmt Band-zu-Band Tunneln exponentiell mit dem elektrischen Feld am Tunnelübergang zu. Mit Simulationsrechnungen wurde berechnet, dass elektrische Streufelder (engl. fringing fields) ausgehend von einem Gatedielektrikum mit sehr hoher Permittivität zu besseren Charakteristiken führen.

L. Knoll, Q.T. Zhao, Lars Knoll, A. Nichau, S. Trellenkamp, S. Richter, A. Schäfer, D. Esseni, L. Selmi, K. K. Bourdelle, S. Mantl, "Inverters With Strained Si Nanowire Complementary Tunnel Field-Effect Transistors", IEEE ELECTRON DEVICE LETTERS VOL. 34, NO. 6, pp. 813-815, 2013. Bisher realisierte Nanodraht Band-zu-Band Tunnel-Feldeffekttransistoren zeigten inverse Unterschwellensteigungen S von weniger als 60 mV/dec, die hauptsächlich auf die verbesserte Steilheit des Tunnelübergangs aufgrund des Einsatzes eines silizidierten Sourcebereichs mit anschließender Dotierstoffsegregation zurückgeführt werden, nur bei sehr geringen Drainströmen.

TFETs sind auch mit Halbleitern mit kleineren Bandlücken vorgeschlagen bzw. hergestellt worden. Aus K. Bhuwalka et al. (P-Channel Tunnel Field Effect Transistors down to Sub-50nm Channel Length" Jap. J. of Appl. Physics 45 (2006) Seiten 3106 - 3109) ist eine Simulation für einen planaren TFET mit Silizium-Germanium (Si-Ge) bekannt, womit der Vorteil der kleineren Bandlücke nachgewiesen werden konnte. Experimentelle Ergebnisse von M. M. Schmidt, R. A. Minamisawa, S Richter, R. Luptak, J.-M. Hartmann, D. Buca, Q. T. Zhao and S. Mantl "Impact of strain and Ge concentration on the performance of planar SiGe band-to-band-tunneling transistors", Proc. of ULIS 2011 Conference, bestätigten diesen Vorteil, allerdings mit S > 60 mV/dec. Bei diesem Ansatz wurde Source, Kanal und Drain aus einer Si-Ge Legierung mit Ge Gehalten von 30 - 65 at-% untersucht.

Auch vertikale $In_{0.53}Ga_{0.47}As_{0.47}$ Band-zu-Band Tunnel-Feldeffekttransistoren lieferten nachteilig bisher nicht die erwarteten Ergebnisse.

Ein weitergehender Ansatz von C. Hu "Green Transistor as a solution to the IC Power Crisis", Proc. of ICSICT Conference, Peking, 2008 (978-1-4244-22186-2/08 @2008 IEEE, nutzt eine komplizierte Heterostruktur, wobei eine dünne Schicht $n^+$-dotiertes verspanntes Silizium unterhalb des Gates auf der Sourceseite bis etwa Gatemitte des Transistors auf $p^+$-dotiertem Ge eingebracht wird. Dadurch entsteht ein Tunnelübergang bestehend aus $p^+$-Ge / $n^+$- verspanntem Silizium. Dieser Ansatz umfasst die oben erwähnten Vorteile der Integration eines Materials mit kleinerer Bandlücke im Tunnelbereich und zudem wird die Fläche des Tunnelüberganges durch die Integration unterhalb des Gates vergrößert. Ein großer Nachteil dieses Konzeptes ist die schwierige Umsetzung, die bisher eine Realisierung verhindert hat.

Auch der Vorschlag von Bhuwalka et al. (Proc. ESSDERC2004, 0-7803-8478-4/04@2004 IEEE), eine ultradünne SiGe Deltaschicht mit scharfen Grenzflächen am Tunnelübergang einzuführen, um den Tunnelstrom zu verbessern, führt nur zu kleinen Verbesserungen.

Aus US 8,258,031 B2 ist die Herstellung eines TFET bekannt, bei dem der Tunnelübergang parallel zum elektrischen Feld des Gates verläuft. Der vertikale Tunnelübergang mit einer gegendotierten Tasche vergrößert die Tunnelquerschnittsfläche und damit den Tunnelstrom. Das Herstellungsverfahren startet dabei mit einer Silizium-auf-einem-Isolator (SOI)-Schicht. Der hochdotierte Tunnelübergang wird über selektives Aufwachsen erhalten, was nachteilig eine Tunnelgrenzfläche mit hoher Defektdichte erzeugen kann. Dies wiederum führt zu einem Tunnelvorgang über diese Defekte und damit zu einer großen inversen Unterschwellensteigung (S).

In der Veröffentlichung von Kanghoon Jeon, Wei-Yip Loh, Pratik Patel, Chang Yong Kang, Jungwoo Oh, Anupama Bowonder, Chanro Park, C. S. Park, Casey Smith, Prashant Majhi, Hsing-Huang Tseng, Raj Jammy, Tsu-Jae King Liu, and Chenming Hu, "Si Tunnel Transistors with a Novel Silicided Source and 46mV/dec Swing", 2010 Symposium on VLSI Technology Digest of Technical Papers, page 121-122) wird über TFETs mit einem Homoübergang berichtet, die einen mit NiSi silizidierten Sourcebereich aufweisen. Die besondere Form der Kanten des silizidierten Bereichs ist jedoch nicht reproduzierbar, wenn Dicke oder Breite der Siliziumschicht variiert werden.

Tunnel-Feldeffektvorrichtungen und Verfahren zur Herstellung von Tunnel-Feldeffektvorrichtungen sind auch aus den Dokumenten US 2012/199917-A1 und DE102010037736-A1 bekannt.

Aufgabe und Lösung

Aufgabe der Erfindung ist es, einen Tunnel-Feldeffekttransistor (TFET) bereit zu stellen, bei dem die Breite der Tunnelbarriere sowie die Größe des Tunnelbereichs durch die Ausrichtung des Tunnelstroms in Bezug auf das elektrische Feld der Gateelektrode effektiv einzustellen ist.

Es ist eine weitere Aufgabe der Erfindung, ein technologisch wenig anspruchsvolles Herstellungsverfahren für den vorgenannten Tunnel-Feldeffekttransistor zur Verfügung zu stellen.

Die Aufgaben werden erfindungsgemäß gelöst durch ein Herstellungsverfahren für einen Tunnel-Feldeffekttransistor gemäß Hauptanspruch 1 und durch einen Tunnel-Feldeffekttransistor (TFET) gemäß Nebenanspruch 10.

Vorteilhafte Ausgestaltungen des Transistors und des Herstellungsverfahrens ergeben sich aus den jeweils darauf rückbezogenen Unteransprüchen 2 - 9 und 11 - 16.

Gegenstand der Erfindung

Im Rahmen der Erfindung wurde ein neuartiger Tunnel-Feldeffekttransistor (TFET) entwickelt, der sowohl in einer planaren Ausführung als auch mit Nanodrähten realisiert werden kann. Dieser besteht aus einem Quellbereich (Source), einem Zielbereich (Drain) und einem Kanal, so dass sich eine p-i-n-Struktur ergibt. In der Regel liegen dabei dotierte Bereiche zur Festlegung von Source und Drain durch einen undotierten Kanal voneinander räumlich getrennt vor. An den Kanal grenzt ein Dielektrikum an, das eine Steuerelektrode (Gate) zur Steuerung des Transistors gegen den Kanal beabstandet. Im Folgenden werden durchgehend die englischsprachigen Begriffe Source, Drain, und Gate verwendet.

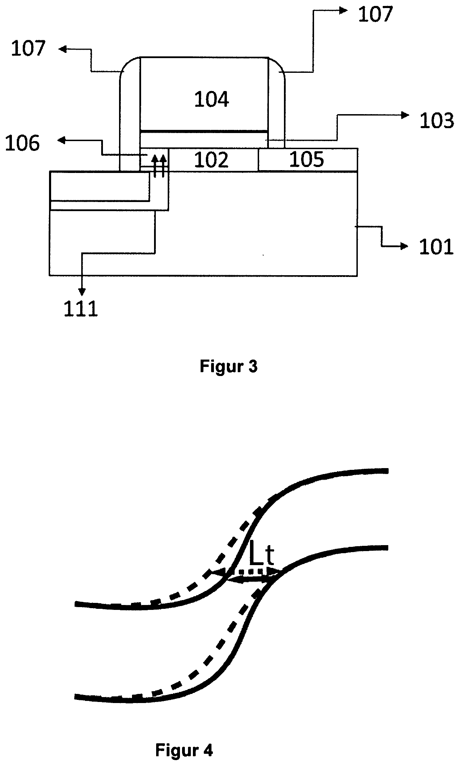

Der erfindungsgemäße Tunnel-Feldeffekttransistor (TFET) weist insbesondere zwei Vorteile gegenüber dem bisherigen Stand der Technik auf. Zum einen werden eine verkürzte Tunnelbarriere und damit ein verkürzter Tunnelübergang bereitgestellt. Dies kann erfindungsgemäß dadurch bewerkstelligt werden, dass im Sourcebereich einerseits eine Silizidierung und zudem eine Dotierstoffsegregation vorgesehen sind, die eine steilere Tunnelflanke bewirken. Andererseits wird durch eine selektive und selbst justierende Silizidierung die Tunnelfläche selbst vergrößert, wobei bei dem erfindungsgemäßen Tunnel-Feldeffekttransistor (TFET) ein Tunnelübergang vorgesehen ist, der parallel zu den elektrischen Feldlinien des Gates verläuft. Dies ist in der Literatur unter dem Begriff "Linientunneln" im Gegensatz zum so genannten "Punkttunneln" bekannt. Der erfindungsgemäße Tunnel-Feldeffekttransistor (TFET) verbindet somit einen Tunnelübergang parallel zu den elektrischen Feldlinien des Gates mit einem vergrößerten Tunnelbereich unterhalb des Gates mit einem Material, welches eine schmalere Bandlücke aufweist, so wie es schematisch in Figur 3 dargestellt ist.

Dieser Tunnelübergang wird dabei in einem Material mit einer kleinen Bandlücke realisiert, beispielsweise in einer dünnen SiGe-Schicht, die pseudomorph auf einer Siliziumschicht aufgewachsen ist und durch eine biaxiale kompressive Verspannung eine verkleinerte Bandlücke bietet. Zwar wird die Erfindung nachfolgend anhand einer SiGe-Schicht näher erläutert, ein Fachmann weiß aber, dass für die Epitaxiesschicht neben SiGe auch andere typische Materialien, wie beispielsweise Si-Ge-Sn, Ge-Sn oder auch nur Ge in Frage kommen.

Die Dicke des Materials der epitaktischen Schicht mit kleiner Bandlücke sollte dabei 10 nm nicht übersteigen, um eine für den Tunnelprozess notwendige Verarmung der Ladungsträger mithilfe des elektrischen Feldes der Steuerelektrode zu ermöglichen. Bei der Siliziumschicht kann es sich beispielsweise um Silizium auf einem Isolator Schicht (SOI, engl. Silicon-on-Insulator) handeln, jedoch ist die Erfindung nicht auf dieses Substrat begrenzt, sondern kann auch auf Standard Silizium Substrate übertragen werden.

Dabei wird erfindungsgemäß ausgehend vom Sourcebereich eine Dotierung vorgenommen, die das Dielektrikum des Gates unterschneidet (Taschenbereich) und somit einen vergrößerten Tunnelbereich ermöglicht. Dabei ist eine Dotierung nicht auf die Möglichkeit der Ionenimplantation beschränkt, sondern kann auch durch eine in-situ Dotierung beim Wachstum der beispielhaften SiGe-Schicht umgesetzt werden. Die Dotierung reicht erfindungsgemäß bis unterhalb des Dielektrikums, um einen Tunnelübergang parallel zu den elektrischen Feldlinien des Gates zu ermöglichen.

Erfolgte die Dotierung beispielsweise über Ionenimplantation kann eine Aktivierung der Dotierstoffe durch Tempern in einer Schutzgasatmosphäre bei niedrigen Temperaturen (< 900 °C) umgesetzt werden, um die kompressive biaxiale Verspannung der beispielhaften SiGe-Schicht durch das pseudomorphe Wachstum zu erhalten.

Auf der Sourceseite wird der dotierte Bereich der epitaktischen Schicht, z. B. der SiGe-Schicht, bis zur Kante des Gates entfernt, so dass nur eine entsprechende dotierte Tasche unterhalb des Gates verbleibt.

Erfindungsgemäß wird im Anschluss daran im Sourcebereich zusätzlich noch ein an den Taschenbereich angrenzender entgegengesetzt dotierter Bereich geschaffen, durch den ein $p^+$-$n^+$-Tunnelübergang und damit das Tunneln parallel zu den elektrischen Feldlinien der Steuerelektrode realisiert wird.

In einer ersten Ausgestaltung der Erfindung wird dazu das Gate an den Seiten mit einer isolierenden Schicht, einem so genannten spacer, versehen, die auf der Drainseite bis auf die dotierte SiGe-Schicht und auf der Sourceseite bis auf die Siliziumschicht reicht. Im Anschluss wird die Siliziumschicht auf der Sourceseite mit einer metallischen Schicht versehen.

Dabei ist bei der Wahl des Metalles darauf zu achten, dass dieses im folgenden Silizidierungsschritt nur mit dem Silizium, nicht aber mit der beispielhaften SiGe-Schicht reagiert und somit eine selbstjustierende, selektive Silizidierung in Bezug auf das Material ermöglicht, in dem der eigentliche Tunnelvorgang stattfindet. Für den Fall einer SiGe-Schicht bietet sich insbesondere Kobalt als Metall für eine selbstjustierende, selektive Silizidierung an. Der eigentliche Silizidierungsschritt erfolgt erneut bei niedrigen Temperaturen unter Formiergas, um die kompressive biaxiale Verspannung der beispielhaften SiGe-Schicht durch das pseudomorphe Wachstum zu erhalten. In der Regel erfolgt die Silizidierung seitlich bis unterhalb des Gates, um eine möglichst große Tunnelfläche zu schaffen.

Danach wird unter Zuhilfenahme einer Implantationsmaske eine Implantation ausschließlich in das Silizid vorgenommen. Es folgt ein sich anschließender Temperschritt bei niedrigen Temperaturen, bei dem diese Dotierstoffe aus dem Silizid in die beispielhafte SiGe-Schicht ausdiffundieren (segregieren), um auf diese Weise einen scharfen $p^+$-$n^+$-Tunnelübergang parallel zu den elektrischen Feldlinien der Steuerelektrode zu erzeugen. Dabei ist der Prozess nicht auf eine Ausdiffusion der Dotierstoffe aus dem Silizid beschränkt, sondern kann auch durch eine zunächst erfolgende Dotierung der Siliziumschicht und anschließende Silizidierung umgesetzt werden (siehe 2. Ausgestaltung). Die Wahl der geeigneten Temperatur und der dazu korrespondierenden Zeit für die Dotierstoffsegregation beeinflussen dabei, wie weit die Dotierstoffe aus dem Silizid in den benachbarten Taschenbereich eindiffundieren, und sind gegebenenfalls von einem Fachmann experimentell vorab zu bestimmen.

In der Figur 4 ist schematisch das Banddiagramm eines Tunnelübergangs dargestellt. Die Breite der Tunnelbarriere ist mit Lt angegeben. Deutlich erkennbar ist die geringere Breite der Tunnelbarriere, die beim Vorhandensein eines entgegengesetzt dotierten Taschenbereichs (durchgezogenen Linien) aufgrund der schmaleren Verarmungszone auftritt, so wie es erfindungsgemäß vorgesehen ist, im Vergleich zu einer aus dem Stand der Technik bekannten Anordnung ohne einen gegendotierten Taschenbereich (gestrichelte Linien).

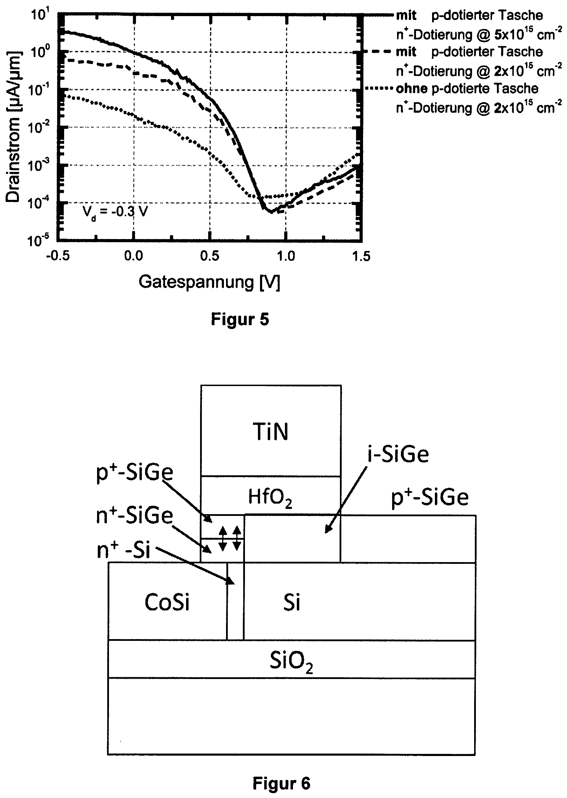

Die selbstjustierende Ausdiffusion aus dem Silizid erzeugt dabei die für den TFET notwendige Source-Dotierung (untere Kurve in Fig. 5). Die entgegengesetzte Dotierung der darüber liegenden Tasche vergrößert die Feldstärke im Tunnelübergang, sodass der Tunnelstrom weiter ansteigt (gestrichelte und gepunktete Linien in Fig.5). Der Begriff selektive selbstjustierende Silizidierung bedeutet in diesem Zusammenhang, dass das spezielle Silzid die beispielhafte SiGe Schicht nicht beeinträchtigt (selektiv), da das Metall nicht mit der SiGe-Schicht reagiert, und dass durch die Dotierung und anschließende Ausdiffusion selbstjustierend die Dotierung des Tunnelüberganges erzeugt wird.

Der selbstjustierende Prozess bei der Herstellung des Tunnelübergangs ist dabei ein wesentlicher Vorteil des erfindungsgemäßen Herstellungsverfahrens. Durch ihn wird es möglich, auf wenige Nanometer genau den Tunnelübergang, das heißt die Trennlinie zwischen den p-n Bereichen, wie in Figur 6 gezeigt, reproduzierbar herzustellen.

Wird die Tunnelverbindung mittels Silizidierung und anschließender Dotierstoffsegregation bei niedrigen Temperaturen (< 700 °C) geschaffen, so ist diese um ein Vielfaches schärfer, als dies bei konventionellen Methoden wie z.B. reiner Ionenimplantation möglich ist. Diese schärfere Tunnelverbindung resultiert in einer verkürzten Tunnelbarriere Lt aufgrund einer reduzierten natürlichen Länge $\Lambda$ bzw. konkret $\Lambda_{ch}$, gemäß Gleichung (1). Durch das Einbringen einer gegendotierten Tasche wird diese Tunnelbarriere Lt noch weiter verkürzt. Des Weiteren fördert eine Dotierstoffsegregation nach erfolgter Silizidierung nicht nur eine vorteilhafte schärfere Tunnelverbindung zu Tage, auch ermöglicht sie höhere absolute Dotierstoffkonzentrationen an der Tunnelverbindung, was eine lineare Ausgangscharakteristik des TFET realisierbar macht.

Ein weiterer Vorteil des erfindungsgemäßen Herstellungsverfahrens ist, dass durch die selbstjustierende Ausdiffusion aus dem Silizid - anders als bei einer in-situ Dotierung - ein besonders defektarmer Tunnelübergang geschaffen werden kann.

Der erfindungsgemäße Tunnelübergang kann sowohl in planaren 1-Gate Transistoren als auch in Multigate-Nanodrähten (so genannten: core-shell nanowire field-effect transistors) umgesetzt werden. Je nach Ausführungsform bieten sich dementsprechend unterschiedliche Herstellungsvarianten an.

Spezieller Beschreibungsteil

Im Weiteren wird die Erfindung an Hand einiger Ausführungsbeispiele und der beigefügten Figuren näher beschrieben, ohne dass es hierdurch zur Einschränkung der Erfindung kommen soll. Es zeigen:

| | |
|---|---|
| Figur 1: | Schematische Darstellung des Einschaltverhaltens von Standard MOSFETs und Band-zu-Band Tunnel-Transistoren (TFET) an Hand einer Transfer-Kennlinie. |
| Figur 2: | Tunnel-Feldeffekttransistor aus dem Stand der Technik. |
| Figur 3: | Eine Ausführungsform des erfindungsgemäßen Tunnel-Feldeffekttransistors. |
| Figur 4: | Schematische Darstellung eines Bändermodells für TFET-Anordnungen mit und ohne Vorhandensein einer gegendotierten Tasche. |
| Figur 5: | Transfercharakteristik (Transfer-Kennlinie) eines planaren p-Typ TFET ohne und mit zwei Ausgestaltungen der Erfindung mit jeweils p-dotierten Taschen direkt unterhalb des Gates, wobei für die Dotierung des Sourcebereiches zwei unterschiedliche Dotierstärken untersucht wurden. |
| Figur 6: | Schematischer Aufbau eines erfindungsgemäßen Tunnel-Feldeffekttransistors mit einer $n^+$-i-$p^+$ Struktur. |
| Figuren 7-12: | Schematische Darstellung der Herstellung einer planaren Ausführungsform des erfindungsgemäßen TFETs. |
| Figuren 15-21: | Schematische Darstellung der Herstellung einer weiteren Ausführungsform des erfindungsgemäßen TFETs mit einem Nanodraht. |

In den Figuren bedeuten dabei:

101: Siliziumsubstrat
102: Epitaktxieschicht, z. B. SiGe-Schicht
103: Dielektrikum für die Gateelektrode
104: Gateelektrode
105: dotiertes Draingebiet
106: dotiertes Taschengebiet
107: seitlich angeordnete Oxidspacer, z. B. aus $SiO_2$ oder Siliziumnitrid
108: Silzid, z. B. CoSi oder $CoSi_2$
109: Maske
110: dotiertes Silizium
111: hochdotierter Halbleiterbereich, durch Segregation von Dotierstoffen aus einem Silizid gebildeter Bereich
121: Nanodraht aus Halbleitermaterial
122: Isolator
123: dotierte Epitaxieschicht, z. B. SiGe-Schicht, bildet den Taschenbereich
124: Dielektrikum für die Gateelektrode
125: Gateelektrode
126: seitlich angeordnete Oxidspacer, z. B. aus $SiO_2$ oder Siliziumnitrid
127: dotiertes Draingebiet
128: Silzid, z.B. CoSi oder $CoSi_2$
129: hochdotierter Halbleiterbereich, durch Segregation von Dotierstoffen aus einem Silizid gebildeter Bereich

Ferner wird mit Sourcebereich der Bereich des Stromzuflusses in den Transistor und mit Drainbereich der Bereich des Stromabflusses aus dem Transistor bezeichnet. Die Steuerung bzw. Verstärkung des Stromflusses zwischen Drain und Source geschieht durch gezieltes Vergrößern und Verkleinern leitender und nichtleitender Gebiete des Halbleitermaterials (Substrat). Das im Vorfeld in der Regel p- und n-dotierte Halbleitermaterial wird dabei durch die an die Steuerelektrode (Gate) angelegte Spannung bzw. das dadurch entstehende elektrische Feld entweder verarmt oder mit Ladungsträgern angereichert.

Die Figur 5 zeigt die Transfercharakteristik (Transfer-Kennlinie, Drainstrom $I_d$ gegen Gatespannung $V_g$) eines planaren p-Typ TFET ohne und mit zwei Ausgestaltungen der Erfindung in Form von p-dotierten Taschen direkt unterhalb des Gates, wobei für die Dotierung des Sourcebereiches zwei unterschiedliche Dotierungsstärken untersucht wurden. Die SiGe-Schicht mit 55 at% Ge hat eine Ausgangsschichtdicke von 5 nm. Der Anstrom (Drainstrom) für die Ausgestaltung mit gegendotierter Tasche steigt um fast zwei Größenordnungen in diesem Experiment an und die inverse Unterschwellensteigung S verbessert sich von 200 mV/dec auf 100 mV/dec. Eine verbesserte technologische Ausführung wird zu S<60 mV/dec und so zu besonders energieeffizienten Transistoren führen. Deutlich erkennbar ist auch die Absenkung des Aus-Stromes (minimaler Strom) für die beiden Ausgestaltungen der Erfindung gegenüber einem Transistor ohne p-dotierte Taschen. Damit kann das Verhältnis von Grenzstrom zu Minimalstrom bei den erfindungsgemäßen Transistoren vorteilhaft wenigstens um den Faktor 50 vergrößert werden. Auch das für TFETs typische ambipolare Verhalten ist bei Einsatz einer Tasche unterdrückt, da auf der Sourceseite das vorteilhafte Linientunneln, auf der Drainseite dagegen Punkttunneln stattfindet.

Figur 6 zeigt den schematischen Aufbau einer Ausführungsform des erfindungsgemäßen Band-zu-Band Tunnel-Feldeffekttransistors (TFET) mit vertikalem Tunnelübergang. Die Gateanordnung wird aus einem hoch permittiven Gatedielektrikum ($HfO_2$) und einem metallischen Gate aus TiN gebildet. Der Kanalbereich aus i-SiGe ist intrinsisch, das heißt nominell undotiert, der Drainbereich ist in diesem Beispiel p-dotiert. Unterhalb des Gates ist auf der Sourceseite die p-dotierte Tasche angeordnet. Sie grenzt an den erfindungsgemäß gegendotierten (n-dotiert) Bereich an, der sich durch die Ausdiffusion des Dotierstoff aus dem siliziderten Bereich gebildet hat, und bildet dort den vertikalen Tunnelübergang aus, der sich regelmäßig über einen Bereich in der Größenordnung um die 10 nm erstreckt.

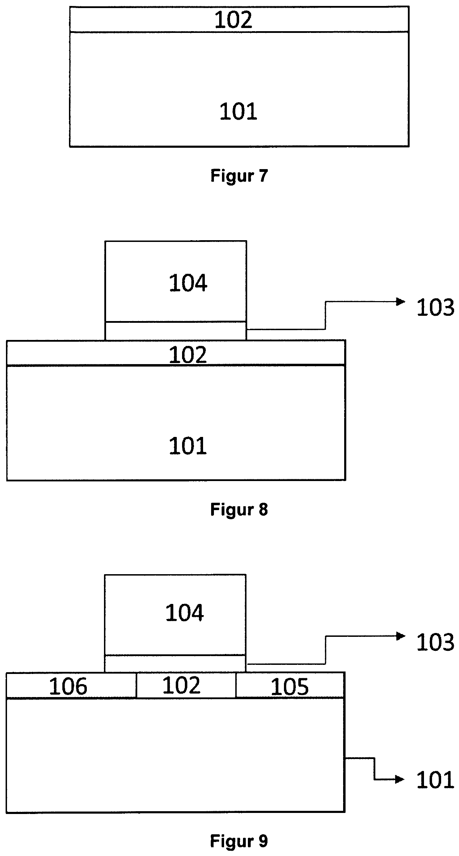

Nachfolgend werden die einzelnen Verfahrensschritte zur Herstellung eines erfindungsgemäßen TFETs exemplarisch anhand eines planaren TFETs in den Figuren 7 bis 12 dargestellt, ohne dass darin eine Einschränkung der Herstellungsvariationen gegeben ist.

In der Figur 7 ist das Si(100)-Substrat 101 mit einer darauf angeordneten halbleitenden Funktionsschicht (Silizium-Germaniumschicht Schicht, $S_{1-x}Ge_x$, mit 0 < x < 1)) 102 dargestellt. Die SiGe-Schicht wurde pseudomorph auf ein Silizium-Substrat 101 aufgewachsen. Dabei reduziert die kompressive, biaxiale Verspanung in der SiGe-Schicht aufgrund des pseudomorphen Wachstums die Bandlücke im Vergleich zu relaxiertem SiGe.

Nach Figur 8 wurde auf dem Siliziumsubstrat 101 mit der darauf angeordneten dünnen, z. B. 5 nm dicken, SiGe-Schicht 102 zunächst das Gate 104 nach Standard-MOSFET-Herstellung erzeugt. Hierzu wurden ganzflächig die nachfolgenden Schichten auf die Silizium-Germaniumschicht 102 abgeschieden. Das Gate-Dielektrikum $HfO_2$ wurde etwa 2 bis 4 nm dick auf die dünne SiGe-Schicht 102, dem späteren Kanal, durch Atomlagenabscheidung (englisch: atomic layer deposition, ALD) abgeschieden. Das TiN Gate 104 wurde mittels gepulster Gasphasenabscheidung aufgebracht. Das gesamte Gate bestehend zum Beispiel aus TiN und Poly-Silizium weist in der Regel eine Gesamtschichtdicke zwischen 40 und 150 nm auf. Das Gate wurde anschließend mittels reaktivem Ionenätzen und selektiver Nass-chemie strukturiert.

Die Figur 9 zeigt den nächsten Verfahrensschritt, bei dem die Silizium-Germaniumschicht 102 einer Dotierung unterzogen wird. Bor-Ionen wurden in die SiGe-Schicht implantiert, um eine p-dotierte Senke (rechte Seite) und eine p-dotierte Tasche (linke Seite) direkt unterhalb der Steuerelektrode zu formen. Dabei wurde die Energie bewusst derart niedrig gewählt, um ausschließlich die SiGe-Schicht und nicht das unterliegende Silizium zu implantieren bzw. zu dotieren. Zusätzlich wurden die Dotierstoffe bei niedrigen Temperaturen (< 900 °C) aktiviert, um eine Relaxation der biaxial kompressiven Verspannung der SiGe-Schicht zu vermeiden.

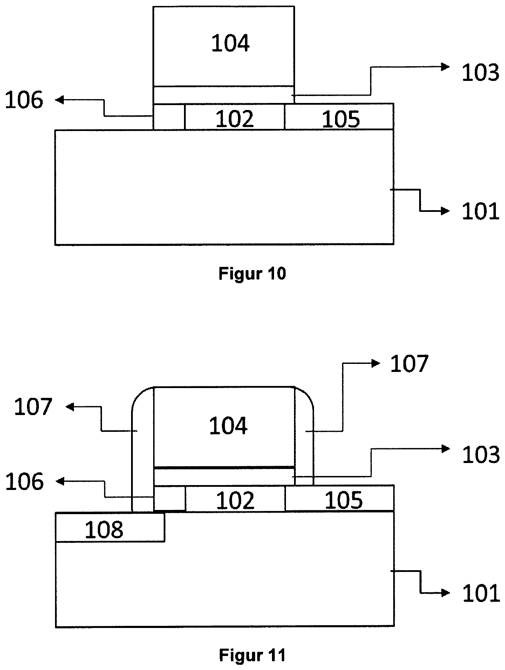

Die Figur 10 zeigt, wie im Anschluss daran der p-dotierte Bereich 106 im Weiteren durch einen Trockenätzschritt bis auf den Bereich direkt unterhalb des Gates vollständig entfernt wurde. Die Trockenätzung erfolgte dabei nicht bis unter das Dielektrikum 103 und das Gate 104. Es verbleibt somit eine p-dotierte Tasche 106 unterhalb des Gates.

Für eine Entfernung des p-dotierten Bereichs bis auf die Siliziumschicht 101 ist es zudem vorteilhaft, wenn die ursprüngliche SiGe-Schicht 102 nicht dicker als 10 nm ist, um eine Verarmung der Ladungsträger in ihr durch das elektrische Feld der Steuerelektrode zu ermöglichen.

Für den nächsten Schritt (siehe Figur 11) der Silizidierung des Sourcebereichs wurden seitlich angeordnete Oxidspacer 107 aus $SiO_2$ oder Siliziumnitrid eingesetzt. Die Oxidspacer wurden nach dem Standardverfahren der MOSFET-Technologie hergestellt. Die Oxidspacer 107 schützen im Weiteren auch das Dielektrikum 103 und das Gate 104.

Anschließend wurde auf die nach der Ätzung frei liegende Siliziumschicht 101 mittels Elektronenstrahlverdampfung ein Metall aufgebracht. Als Metalle geeignet sind dabei solche Metalle, die zwar mit dem Silizium der Si-Schicht nicht aber mit der SiGe-Schicht reagieren, wobei die SiGe Schicht exemplarisch zu verstehen ist. Für das Materialsystem Si-SiGe eignet sich Kobalt, da die Bildung von Kobaltsilizid an der Si/SiGe-Grenzfläche vorteilhaft von selbst stoppt. Ge wird nicht in das Silizid eingebaut. Im Gegensatz dazu würde das für die Silizidierung meist verwendete Ni eine Ni-Si-Ge Verbindung bilden und so die SiGe Kanalschicht angreifen. Optional kann auf die erste Metallschicht noch eine weitere Schicht zum Schutz dieser vor Oxidation aufgebracht werden.

Danach wurde der Sourcebereich einem Silizidierungsschritt unterzogen, bei dem das Metall aus der Metallschicht in die Siliziumschicht eindiffundiert und mit dem Silizium eine metallische Verbindung, ein Silizid, bildet. Es entstand der Silizidbereich 108, der sowohl den Oxidspacer 107 auf der Sourceseite als auch den Taschenbereich 106 unterschneiden kann.

Eine Maskierung 109 begrenzt die folgende Dotierung auf den Sourcebereich. Diese kann über eine Ionenimplantation mit anschließender Temperaturbehandlung oder auch über andere Dotierstoff-Diffusionsprozesse realisiert werden. Die Dotierung auf der Sourceseite erfolgt dabei entgegengesetzt zu der dotierten Tasche 106 und dem Drainbereich 105, in diesem Fall also als n-Dotierung mittels Phosphor.

Unmittelbar nach der Dotierung des silizidierten Bereichs 108 mit den Phosphorionen wurde der Transistor bei 500 °C für 10 Sekunden in einer Stickstoffatmosphäre behandelt, wobei Phosphor aus dem Kobaltsilizid 108 einerseits in das Si-Substrat 101 und entscheidend seitlich, bzw. nach oben bis in die p-dotierte SiGe-Schicht (dotierte Tasche) 106 ausdiffundiert. Vorteilhaft bei diesem Verfahren ist, dass die Ausdiffusion z. B. des Phosphors aus dem Silizid durch das thermische Budget (z. B. 500 °C für 10 s) exakt, auf wenige Nanometer genau kontrolliert werden kann, die für Tunnel-FETs wichtigen steile Dotierprofile erzeugt werden können und die thermische Ausdiffusion im Gegensatz zur direkten Ionenimplantation keine Kristalldefekte in der SiGe Schicht erzeugt. Das ist wichtig, um unerwünschtes Defekt-induziertes Tunneln, das S des Tunnel-FETs degradiert, zu minimieren.

Durch die Wahl der Verfahrensparameter kann somit vorteilhaft erreicht werden, dass das Phosphor nur wenige Nanometer in das SiGe des entgegengesetzt dotierten Taschenbereichs eindiffundiert, so dass sich der p-n-Übergang (= Tunnelübergang) vorzugsweise in etwa der Mitte der SiGe-Schicht ausbildet.

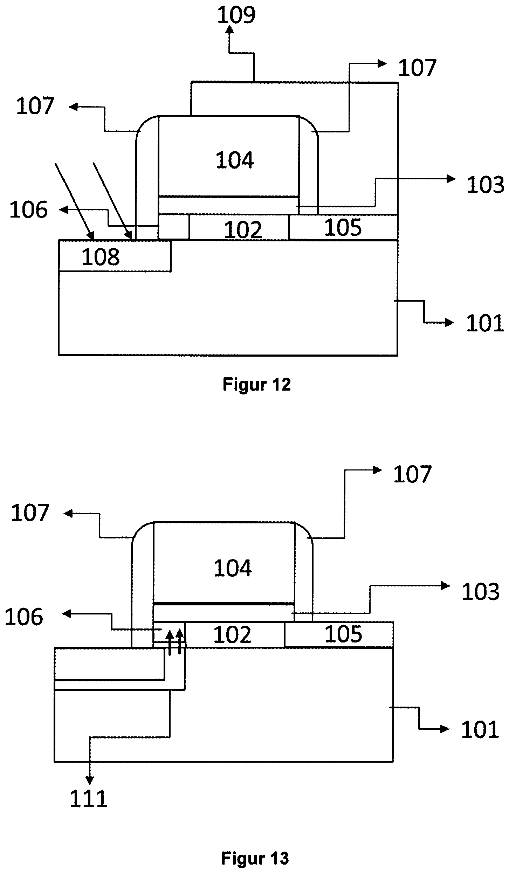

Auf diese Weise konnte ein vertikaler $n^+$-p Band-zu-Band-Tunnelübergang (angedeutet durch Pfeile in der Figur 13) innerhalb der SiGe-Schicht und direkt unterhalb des Gates geformt werden. Die Dotierstoffkonzentration des $n^+$-Sourcebereichs 111 sollte im Falle von Silizium im $10^{20}$ cm$^{-3}$-Bereich liegen, wohingegen die Dotierstoffkonzentration der gegendotierten Tasche 106 je nach Anforderung zwischen $10^{18}$ cm$^{-3}$ bis $10^{20}$ cm$^{-3}$ variiert werden kann, um eine lineare Ausgangscharakteristik des planaren TFETs zu ermöglichen.

Der erfindungsgemäße Band-zu-Band Tunnelfeldeffekttransitor (TFET) kann auch auf eine alternative Weise hergestellt werden. Die alternative Herstellungsroute verläuft dabei zunächst gemäß der Verfahrensschritte, wie sie in den Figuren 7 bis 10 dargestellt sind.

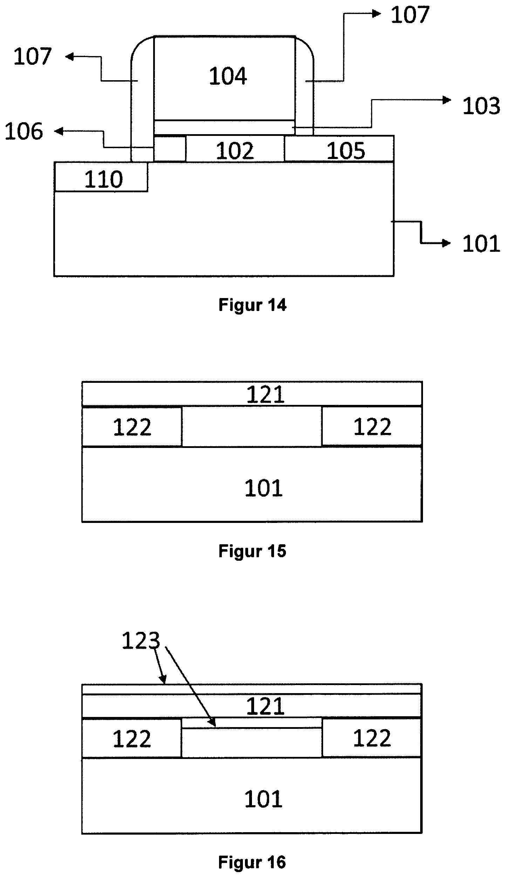

In die nach der Ätzung frei liegende Siliziumschicht 101 wird nunmehr jedoch zunächst eine Dotierung vorgenommen. Diese kann über eine Ionenimplantation oder auch über andere Diffusionsprozesse realisiert werden. Die Dotierung auf der Sourceseite erfolgt dabei entgegengesetzt zu der dotierten Tasche 106 und ggfs. dem Dranbereich 105, in diesem Beispiel also als n-Dotierung mittels Phosphorionen (siehe Figur 14). Die Dotierung darf auch bis zur Tasche erfolgen, sollte jedoch die ursprüngliche Dotierung nicht überdecken, da dann kein $n^+$-$p^+$-Tunnelübergang mehr gegeben ist. Eine Aktivierung kann bereits direkt nach der Dotierung erfolgen, kann aber auch durch den folgenden Silizidierungsschritt nachgeholt werden.

Im Anschluss daran wird auf die nunmehr n-dotierte Siliziumschicht 110 mittels Elektronenstrahlverdampfung ein Metall aufgebracht. Als Metalle geeignet sind dabei solche Metalle, die zwar mit dem Silizium der Si-Schicht nicht aber mit der SiGe-Schicht reagieren. Optional kann auf diese auch noch eine weitere Schicht zum Schutz der Metallschicht vor Oxidation aufgebracht werden.

Danach wird der bereits n-dotierte Sourcebereich einem Silizidierungsschritt unterzogen, bei dem das Metall aus der Metallschicht durch die n-dotierte Siliziumschicht seitlich bis in die Si-Schicht 101 und insbesondere bis zur Si-Ge-Grenzfläche eindiffundiert und ein Silizid bildet, und dort den erfindungsgemäßen vorteilhaften vertikalen $n^+$-$p^+$-Tunnelübergang 111 schafft.

Der vorgenannte beispielhaft beschriebene Herstellungsprozess kann zudem auch für sehr kleine Strukturen wie beispielsweise für Fin- oder Nanodraht-TFETs mit Multigates herangezogen werden.

Nachfolgend wird anhand der Figuren 15 bis 21 ein weiteres beispielhaftes Herstellungsverfahren veranschaulicht, ohne dass dies als Einschränkung zu betrachten ist. Dabei werden die Gates um die TFETs herum angeordnet, wobei der Tunnelübergang jeweils parallel zum elektrischen Feld des Gates angeordnet ist und jeweils auf der Sourceseite eine selektive Silizidierung sowie eine Dotierungsauslagerung durch Dotierstoffsegregation vorgesehen sind, um den erfindungsgemäßen Tunnelübergang bereitzustellen.

Die Figur 15 zeigt einen freistehenden Halbleiter-Nanodraht 121, beispielsweise aus Silizium, der auf Isolationsschichten 122 angeordnet ist, die wiederum auf einem Substrat 101 angeordnet sind. Arrays mit parallel ausgerichteten Mehrfachdrähten können sowohl mittels Lithographie kombiniert mit Ätzverfahren direkt hergestellt oder durch Nanodraht-Wachstum hergestellt werden.

In einem nächsten Schritt erfolgt das Aufwachsen einer Epitaxieschicht 123 konform um den Nanodraht 121 herum, beispielsweise mit chemischer Gasphasenabscheidung (engl. Chemical vapor deposition). Die Epitaxieschicht 123 kann beispielsweise eine hoch dotierte Halbleiterschicht mit einer kleinen Bandlücke und mit einer Schichtdicke von weniger als 10 nm sein. Als geeignete Materialien für eine solche Schicht sind insbesondere SiGe, Ge, GeSn oder SiGeSn zu nennen, aber erfindungsgemäß können auch andere Halbleitermaterialien verwendet werden

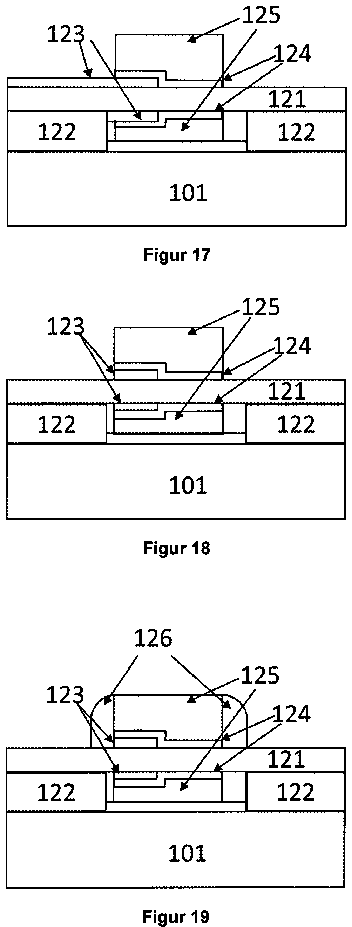

Nach der selektiven Entfernung der Epitaxieschicht auf der Drainseite und einem Teil des Kanalbereiches wird standardmäßig die Gateanordnung in diesem Fall ringartig ausgebildet. Dazu wird zunächst ein Gatedielektrikum 124 und anschließend das Gatemetall 125 entsprechend aufgebracht und angeordnet, so wie es in der Figur 17 dargestellt ist.

Im Anschluss wird die Epitaxieschicht 123, die nicht durch das Gate abgedeckt ist, entfernt, so dass - wie in Figur 18 ersichtlich - eine umlaufende dotierte (Ring-)Tasche unterhalb des Gatedielektrikums verbleibt, so dass ein Ringgate (eng. Gate-All-Around (GAA)), das optimale elektrostatische Kontrolle des Bauelementes garantiert Dies ist für Tunnel-FETs besonders vorteilhaft, da dadurch im Tunnelübergang durch die angelegte Gatespannung besonders hohe Feldstärken erreicht werden können, was die Tunnelwahrscheinlichkeit und somit den Drainstrom erhöht.

Es folgt der Schutz der Gateanordnung durch seitlich angeordnete Oxidspacer 126 aus $SiO_2$ oder Siliziumnitrid.

Dazu wurde bei der Anordnung gemäß der Figur 19 zunächst ein silizidierter Bereich 128 auf der Sourceseite geschaffen, wobei die selektive, selbst justierende Silizidierung lediglich den Nanodraht 121 und nicht die dotierte Tasche 123 betrifft. Optional kann eine Silizidierung auch auf der Drainseite erfolgen. Es folgt eine entgegengesetzt zur Tasche Dotierung des silizidierten Bereichs 128 auf der Sourceseite und anschließend die Ausdiffusion der Dotierstoffe aus dem Silizid heraus bis an die Tasche 123, wodurch der erfindungsgemäße hoch dotierte, silizidierte Bereich 129 entsteht.

Auch in diesen Fall ist es unerheblich, ob der erfindungsgemäße hoch dotierte, silizidierte Bereich 129 zunächst durch eine selektive Silizidierung mit anschließender Dotierung und Ausdiffusion geschaffen wird, oder ob alternativ der Bereich 129 durch eine zunächst erfolgte Dotierung der Siliziumschicht und anschließende Silizidierung und Ausdiffusion geschaffen wird.

Im Anschluss wird noch ein dotierter Drainbereich 127 durch Dotierung des Nanodrahts 121 ausgebildet, wobei die Dotierung auf der Drainseite 127 entgegengesetzt zur Dotierung des hoch dotierten, silizidierten Bereichs 129 gewählt wird.

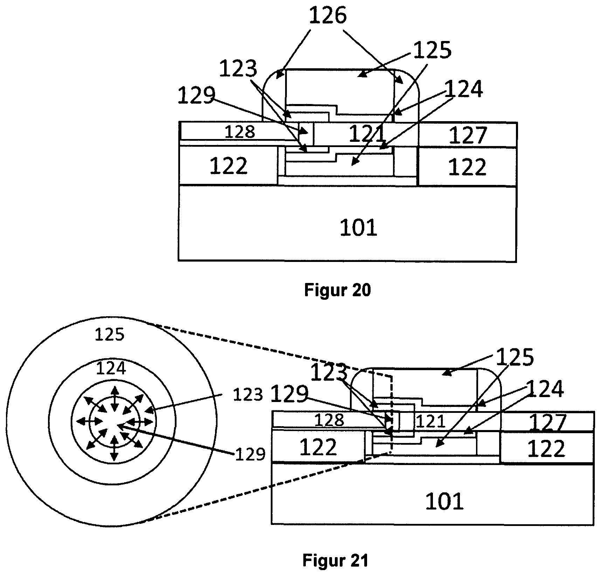

In der Figur 21 ist der Transistor gemäß der Anordnung aus Figur 20 im Querschnitt dargestellt. Die Schnittebene ist in Figur 20 durch eine gestrichelte Linie angedeutet. Bei Anlegen einer Gatespannung erfolgt das Tunneln (angedeutet durch Pfeile) an der Grenzfläche zwischen dem zentral angeordneten hoch dotierten, silizidierten Bereich 129 des Nanodrahtes und der gegendotierten umlaufenden Tasche 123.

Ein besonderes Merkmal dieser Ausgangsgestaltung ist, dass diese fast ausschließlich Line-Tunneln ermöglicht, das gegenüber konventionellen Ausführungen mit Punkt-Tunneln höhere Tunnelströme und vor allem kleinere Unterschwellensteigungen (S) erreicht werden können. Letzteres ist Voraussetzung für eine hohe Energieeffizienz der Transistoren.

**Patentansprüche**

1. Verfahren zur Herstellung eines Tunnel Feldeffekttransistors, TFET, umfassend einen Source-, Kanal- und Drainbereich, mit den Schritten

   - auf einem Siliziumsubstrat (101, 121) wird eine Epitaxieschicht (102, 123) angeordnet,
   - auf dieser wird eine Gateanordnung mit einer Gatelektrode (104, 125) aufgebracht, wobei ein Gatedielektrikum (103, 124) zwischen der Gatelektrode und dem Si-Substrat angeordnet wird,
   - unterhalb des Gatedielektrikums (103, 124) wird benachbart zum Sourcebereich ein dotierter Taschenbereich (106,123) ausgebildet,
   **dadurch gekennzeichnet, dass**
   - im Sourcebereich ein selektiv silizidierter Bereich (108, 128) ausgebildet wird, der bis unterhalb der Gateanordnung reicht, und
   - im Sourcebereich zusätzlich durch Ausdiffusion von Dotierstoffen aus dem silizidierten Bereich (108, 128) benachbart zum Taschenbereich (106, 128) und zumindest teilweise unterhalb des Taschenbereichs ein entgegengesetzt zum Taschenbereich dotierter Bereich (111, 129) ausgebildet wird, wodurch ein Tunnelübergang und damit im Betrieb das Tunneln parallel zu den elektrischen Feldlinien der Gateelektrode (104, 125) realisiert wird.

2. Verfahren nach Anspruch 1, bei dem für die Epitaxieschicht Si-Ge, Ge, Ge-Sn oder Si-Ge-Sn verwendet wird.

3. Verfahren nach einem der Ansprüche 1 bis 2, bei dem der dotierte Bereich (111, 129) durch eine selektive Silizidierung des Sourcebereichs (108, 128), eine sich anschließende Dotierung sowie eine sich anschließende Ausdiffusion der Dotierstoffe erzeugt wird.

4. Verfahren nach einem der Ansprüche 1 bis 3, bei dem der dotierte Bereich (111, 129) durch eine Dotierung des Sourcebereichs (110), eine sich anschließende selektive Silizidierung sowie eine sich anschließende Ausdiffusion der Dotierstoffe erzeugt wird.

5. Verfahren nach einem der Ansprüche 1 bis 4, bei dem die Ausdiffusion von Dotierstoffen aus dem silizidierten Bereich (108, 128) bis in den Taschenbereich (106, 128) erfolgt.

6. Verfahren nach einem der Ansprüche 1 bis 5, bei dem der dotierte Bereich (111, 129) selbstjustierend ausgebildet wird.

7. Verfahren nach einem der Ansprüche 1 bis 6, bei dem ein planares Si-Substrat eingesetzt wird und der entgegengesetzt dotierte Bereich (111) unterhalb des dotierten Taschenbereichs (106) erzeugt wird.

8. Verfahren nach einem der Ansprüche 1 bis 6, bei dem ein Si-Nanodraht eingesetzt wird und der entgegengesetzt dotierte Bereich (129) im Zentrum eines umlaufenden dotierten Taschenbereichs (123) erzeugt wird.

9. Verfahren nach einem der Ansprüche 1 bis 8, bei dem der Drainbereich (105) identisch zum dotierten Taschenbereich (106,123) dotiert wird.

10. Tunnel Feldeffekttransistor (TFET) umfassend

    - ein Si-Substrat (101, 121),
    - eine darauf angeordnete Epitaxieschicht (102, 123)
    - eine darauf angeordnete Gateanordnung, mit einer Gatelektrode (104, 125) und einem zwischen der Gatelektrode und dem Si-Substrat angeordneten Gatedielektrikum (103, 124),
    - einen unterhalb des Gatedielektrikums angeordneten Kanal (102, 121) sowie ein daran angrenzender Drainbereich (105, 127),
    - einen unterhalb des Gatedielektrikums (103, 124) und benachbart zum Kanal (102, 121) angeordneten dotierten Taschenbereich (106, 123), sowie ein daran angrenzender Sourcebereich, wobei der Sourcebereich einen entgegengesetzt zum Taschenbereich (106, 123) dotierten Bereich (111, 129) aufweist, der benachbart zum gegendotierten Taschenbereich und zumindest teilweise unterhalb dessen angeordnet ist, und wobei ein vertikaler Tunnelübergang parallel zu den elektrischen Feldlinien der Gateelektrode (104, 125) vorliegt, durch welchen im Betrieb das Tunneln parallel zu den elektrischen Feldlinien der Gateelektrode erfolgt **dadurch gekennzeichnet,**
- **dass** der Sourcebereich einen silizidierten Bereich (108, 128) aufweist, der zumindest teilweise unterhalb der Gateanordnung angeordnet ist, und
- **dass** der entgegengesetzt zum Taschenbereich (106, 123) dotierten Bereich (111, 129) benachbart zum silizidierten Bereich (108, 128) angeordnet ist.

11. Tunnel Feldeffekttransistor (TFET) nach Anspruch 10, bei dem die Epitaxieschicht, Si-Ge, Ge, Ge-Sn oder Si-Ge-Sn aufweist.

12. Tunnel Feldeffekttransistor (TFET) nach einem der Ansprüche 10 bis 11, bei dem der entgegengesetzt zum Taschenbereich (106, 123) dotierte Bereich (111, 129) eine Schichtdicke zwischen 3 nm und 5 nm aufweist.

13. Tunnel Feldeffekttransistor (TFET) nach einem der Ansprüche 10 bis 12, mit einem planaren Si-Substrat (101), bei dem der entgegengesetzt zum Taschenbereich (106) dotierte Bereich (111) unterhalb des Taschenbereichs angeordnet ist.

14. Tunnel Feldeffekttransistor (TFET) nach einem der Ansprüche 10 bis 12, mit einem Nanodraht (121) als Si-Substrat, einem ringförmigen Taschenbereich (123) und einer ringförmig angeordneten Gateanordnung (124, 125), bei dem der entgegengesetzt zum ringförmigen Taschenbereich dotierte Bereich (129) im Zentrum des Taschenbereichs (123) angeordnet ist.

15. Tunnel Feldeffekttransistor (TFET) nach einem der Ansprüche 11 bis 14, bei dem der Sourcebereich (128, 129), der Kanal (121) und der Drainbereich (127) innerhalb eines Nanodrahts ausgebildet sind.

16. Tunnel Feldeffekttransistor (TFET) nach einem der Ansprüche 11 bis 15, bei dem der gegendotierte Taschenbereich eine Dotierstoffkonzentration zwischen $10^{18}$ cm$^{-3}$ bis $10^{20}$ cm$^{-3}$ aufweist.

**Claims**

1. Method for producing a tunnel field effect transistor, TFET, comprising a source, channel and drain area, with the steps

   - an epitaxy layer (102, 123) is arranged on a silicon substrate (101, 121),
   - a gate arrangement with a gate electrode (104, 125) is applied to this,
   in which a gate dielectric (103, 124) is arranged between the gate electrode and the Si substrate,
   - a doped pocket area (106, 123) is formed below the gate dielectric (103, 124) adjacent to the source area,
   ***characterised in that***
   - a selective silicidised area (108, 128) is formed in the source area, which reaches below the gate arrangement, and
   - a doped area (111, 129) opposite the pocket area is formed in the source area as well by diffusing out dopants from the silicidised area (108, 128) adjacent to the pocket area (106, 128) and at least partly below the pocket area, through which a tunnel crossing and therefore in operation tunnelling is carried out parallel to the electrical field lines of the gate electrode (104, 125).

2. Method according to claim 1, in which Si-Ge, Ge, Ge-Sn or Si-Ge-Sn is used for the epitaxy layer.

3. Method according to one of claims 1 to 2, in which the doped area (111, 129) is produced by selective silicidisation of the source area (108, 128), then doping and then diffusing out the dopants.

4. Method according to one of claims 1 to 3, in which the doped area (111, 129) is produced by doping the source area (110), then selective silicidisation and then diffusing out the dopants.

5. Method according to one of claims 1 to 4, in which diffusing out dopants from the silicidised area (108, 128) is also carried out in the pocket area (106, 128).

**6.** Method according to one of claims 1 to 5, in which the doped area (111, 129) is made self-adjusting.

**7.** Method according to one of claims 1 to 6, in which a planar Si substrate is used and the doped area (111) opposite is produced below the doped pocket area (106).

**8.** Method according to one of claims 1 to 6, in which a Si nanowire is used and the doped area (129) opposite is produced in the centre of a surrounding doped pocket area (123).

**9.** Method according to one of claims 1 to 8, in which the drain area (105) is doped identically to the doped pocket area (106, 123).

**10.** Tunnel field effect transistor (TFET) comprising

- a Si substrate (101, 121),
- an epitaxy layer (102, 123) arranged on top
- a gate arrangement arranged on top, with a gate electrode (104, 125) and a gate dielectric (103, 124) arranged between the gate electrode and the Si substrate,
- a channel (102, 121) arranged below the gate dielectric
and a drain area (105, 127) bordering it,
- a doped pocket area (106, 123) arranged below the gate dielectric (103, 124) and adjacent to the channel (102, 121), and a source area bordering it,
in which
the source area has a doped area (111, 129) opposite the pocket area (106, 123), which is arranged adjacent to the counter doped pocket area and at least partly below it, and in which there is a vertical tunnel crossing parallel to the electrical field lines of the gate electrode (104, 125), through which in operation tunnelling is carried out parallel to the electrical field lines of the gate electrode,
**characterised in that**
- the source area has a silicidised area (108, 128), which is arranged at least partly below the gate arrangement, and
- the doped area (111, 129) opposite the pocket area (106, 123) is arranged adjacent to the silicidised area (108, 128).

**11.** Tunnel field effect transistor (TFET) according to claim 10, in which the epitaxy layer has Si-Ge, Ge, Ge-Sn or Si-Ge-Sn.

**12.** Tunnel field effect transistor (TFET) according to one of claims 10 to 11, in which the doped area (111, 129) opposite the pocket area (106, 123) has a layer thickness between 3 nm and 5 nm.

**13.** Tunnel field effect transistor (TFET) according to one of claims 10 to 12, with a planar Si substrate (101), in which the doped area (111) opposite the pocket area (106) is arranged below the pocket area.

**14.** Tunnel field effect transistor (TFET) according to one of claims 10 to 12, with a nanowire (121) as Si substrate, a ring-shaped pocket area (123) and a gate arrangement (124, 125) arranged ring-shaped, in which the doped area (129) opposite the ring-shaped pocket area is arranged in the centre of the pocket area (123).

**15.** Tunnel field effect transistor (TFET) according to one of claims 11 to 14, in which the source area (128, 129), the channel (121) and the drain area (127) are formed inside a nanowire.

**16.** Tunnel field effect transistor (TFET) according to one of claims 11 to 15, in which the counter doped pocket area has a dopant concentration between $10^{18}$ cm$^{-3}$ to $10^{20}$ cm$^{-3}$.

**Revendications**

**1.** Procédé de fabrication d'un transistor à effet de champ tunnel, TFET, comprenant
une zone de source, une zone de canal et une zone de drain,
par les stades

- on met, sur un substrat (101, 121) en silicium, une couche (102, 123) d'épitaxie,
- on dépose sur celle-ci un agencement de grille ayant une électrode (104, 125) de grille,
dans lequel
on met un diélectrique (103, 124) de grille entre l'électrode de grille et le substrat en Si,
- en dessous du diélectrique (103, 124) de grille, on constitue, au voisinage de la région de source, une région (106, 123) de poche dopée,
**caractérisé en ce que**
- on constitue, dans la zone de source, une zone (108, 128) siliciurée sélectivement, qui va jusqu'en dessous de l'agencement de grille et
- on constitue dans la zone de source, en plus par diffusion de substances dopées, à partir de la zone (108, 128) siliciurée au voisinage de la région (106, 128) de poche et, au moins en partie en dessous de la zone de poche, une zone (111, 129) dopée de manière opposée à la zone de poche, grâce à quoi il est réalisé une jonction tunnel et il est ainsi réalisé, en fonctionnement, l'effet tunnel parallèlement aux lignes de champ électriques de l'électrode (104, 125) de grille.

2. Procédé suivant la revendication 1, dans lequel on utilise pour la couche d'épitaxie Si-Ge, Ge, Ge-Sn ou Si-Ge-Sn.

3. Procédé suivant l'une des revendications 1 à 2, dans lequel on produit la zone (111, 129) dopée, par une siliciuration sélective de la zone (108, 128) de source, un dopage qui vient ensuite, ainsi qu'une diffusion qui vient ensuite de la substance dopante.

4. Procédé suivant l'une des revendications 1 à 3, dans lequel on produit la zone (111, 129) dopée, par un dopage de la zone (110) de source, une siliciuration sélective qui vient ensuite, ainsi qu'une diffusion qui vient ensuite de la substance dopante.

5. Procédé suivant l'une des revendications 1 à 4, dans lequel la diffusion de substances de dopage s'effectue de la zone (108, 128) siliciurée jusque dans la zone (106, 128) de poche.

6. Procédé suivant l'une des revendications 1 à 5, dans lequel on constitue la zone (111, 129) dopée à auto-alignement.

7. Procédé suivant l'une des revendications 1 à 6, dans lequel on utilise un substrat en Si planar et on produit la zone (111) dopée de manière opposée en dessous de la zone (106) de poche dopée.

8. Procédé suivant l'une des revendications 1 à 6, dans lequel on utilise un nanofil en Si et on produit la zone (129) dopée de manière opposée au centre d'une zone (123) de poche dopée faisant le tour.

9. Procédé suivant l'une des revendications 1 à 8, dans lequel on dope la zone (105) de drain de la même façon que la zone (106, 123) de poche dopée.

10. Transistor à effet de champ tunnel (TFET) comprenant

- un substrat (101, 121) en Si,
- une couche (102, 123) d'épitaxie mise dessus,
- un agencement de grille mis dessus ayant une électrode (104, 125) de grille et un diélectrique (103, 124) de grille disposé entre l'électrode de grille et le substrat en Si,
- un canal (102, 121) disposé en dessous du diélectrique de grille,
ainsi qu'une zone (105, 127) de drain qui en est voisine,
- une zone (106, 123) de poche dopée disposée en dessous du diélectrique (103, 124) de grille et au voisinage du canal (102, 121), ainsi qu'une zone de source qui en est voisine,
dans lequel
la zone de source a une zone (111, 129) dopée de manière opposée à la zone (106, 123) de poche, zone (111, 129) dopée qui est disposée au voisinage de la zone de poche de dopage opposée et, au moins en partie, en dessous de celle-ci et dans lequel il y a, parallèlement aux lignes de champ électriques de l'électrode (104, 125) de grille, une jonction tunnel verticale, par laquelle, en fonctionnement, il se produit un effet tunnel parallèlement aux lignes de champ électriques de l'électrode de grille, **caractérisé en ce que**
- la zone de source a une zone (108, 128) siliciurée, qui est disposée, au moins en partie, en dessous de l'agencement de grille et
- la zone (111, 129) dopée de manière opposée à la zone (106, 123) de poche est disposée au voisinage de la zone (108, 128) siliciurée.

**11.** Transistor à effet de champ tunnel (TFET) suivant la revendication 10, dans lequel la couche d'épitaxie comporte du Si-Ge, Ge, Ge-Sn ou Si-Ge-Sn.

**12.** Transistor à effet de champ tunnel (TFET) suivant l'une des revendications 10 à 11, dans lequel la zone (111, 129) dopée de manière opposée à la zone (106, 123) de poche a une épaisseur de couche entre 3 nm et 5 nm.

**13.** Transistor à effet de champ tunnel (TFET) suivant l'une des revendications 10 à 12, comprenant un substrat (101) en Si planar, dans lequel la zone (111) dopée de manière opposée à la zone (106) de poche est disposée en dessous de la zone de poche.

**14.** Transistor à effet de champ tunnel (TFET) suivant l'une des revendications 10 à 12, comprenant un nanofil (121) comme substrat en Si, une zone (123) de poche annulaire et un agencement (124, 125) de grille disposé de manière annulaire, dans lequel la zone (129) dopée de manière opposée à la zone de poche annulaire est disposée au centre de la zone (123) de poche.

**15.** Transistor à effet de champ tunnel (TFET) suivant l'une des revendications 11 à 14, dans lequel la zone (128, 129) de source, le canal (121) et la zone (127)de drain sont constitués au sein d'un nanofil.

**16.** Transistor à effet de champ tunnel (TFET) suivant l'une des revendications 11 à 15, dans lequel la zone de poche dopée de manière opposée a une concentration de substances de dopage comprise entre $10^{18}$ cm$^{-3}$ et $10^{20}$ cm$^{-3}$.

**Figur 1**

**Figur 2**

**Figur 3**

**Figur 4**

**Figur 5**

**Figur 6**

**Figur 7**

**Figur 8**

**Figur 9**

**104**

**106** ← **102** **105** → **103**

→ **101**

**Figur 10**

→ **107**

**107** ← **104** → **107**

**106** ← **102** **105** → **103**

**108**

→ **101**

**Figur 11**

**Figur 12**

**Figur 13**

**Figur 14**

**Figur 15**

**Figur 16**

**Figur 17**

**Figur 18**

**Figur 19**

**Figur 20**

**Figur 21**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8258031 B2
- US 2012199917 A1
- DE 102010037736 A1

**In der Beschreibung aufgeführte Nicht-Patentliteratur**

- **L. KNOLL ; Q.T. ZHAO ; LARS KNOLL ; A. NICHAU ; S. TRELLENKAMP ; S. RICHTER ; A. SCHÄFER ; D. ESSENI ; L. SELMI ; K. K. BOURDELLE.** Inverters With Strained Si Nanowire Complementary Tunnel Field-Effect Transistors. *IEEE ELECTRON DEVICE LETTERS,* 2013, vol. 34 (6), 813-815
- **K. BHUWALKA et al.** P-Channel Tunnel Field Effect Transistors down to Sub-50nm Channel Length. *Jap. J. of Appl. Physics,* 2006, vol. 45, 3106-3109
- **VON M. M. SCHMIDT ; R. A. MINAMISAWA ; S RICHTER ; R. LUPTAK ; J.-M. HARTMANN ; D. BUCA ; Q. T. ZHAO ; S. MANTL.** Impact of strain and Ge concentration on the performance of planar SiGe band-to-band-tunneling transistors. *Proc. of ULIS 2011 Conference*
- Green Transistor as a solution to the IC Power Crisis. **VON C. HU.** Proc. of ICSICT Conference. 2008
- **VON BHUWALKA et al.** Proc. ESSDERC2004
- **VON KANGHOON JEON ; WEI-YIP LOH ; PRATIK PATEL ; CHANG YONG KANG ; JUNGWOO OH ; ANUPAMA BOWONDER ; CHANRO PARK ; C. S. PARK ; CASEY SMITH ; PRASHANT MAJHI.** Si Tunnel Transistors with a Novel Silicided Source and 46mV/dec Swing. *Symposium on VLSI Technology Digest of Technical Papers,* 2010, 121-122